# EUROPÄISCHE PATENTSCHRIFT

(11) **EP 0 407 879 B1**
(45) Veröffentlichungstag und Bekanntmachung des Hinweises auf die Patenterteilung: **05.07.1995**
(21) Anmeldenummer: 90112754.8
(22) Anmeldetag: 04.07.1990
(51) Int. Cl.: G01R 33/48

(54) **Verfahren zur mehrdimensionalen Messung von magnetischer Resonanz in definierten kleinen Volumenbereichen einer Festkörper-Probe**
Method for mutli-dimensional measurement of magnetic resonance in defined small volume regions of a solid-state sample
Procédé de mesure de la résonance magnétique multidimensionnelle dans des petits volumes définis d'un échantillon solide

(30) Priorität: 08.07.1989 DE 3922505
(43) Veröffentlichungstag der Anmeldung: 16.01.1991
(73) Patentinhaber: Bruker Medizintechnik GmbH, D-76287 Rheinstetten (DE)
(72) Erfinder: Kimmich, Rainer, Prof.-Dr., D-7900 Ulm (DE); Rommel, Eberhard, Dr. Dipl.-Ing., D-7900 Ulm-Gögglingen (DE); Hafner, Siegfried, Dipl.-Phys., D-7906 Blaustein (DE)
(74) Vertreter: Witte, Alexander, Dr.-Ing.

(56) Entgegenhaltungen:
- EP-A- 0 259 998
- PHYSICAL REVIEW, Band 157, Nr. 2, 10. Mai 1967, Seiten 232-240, New York, US; J. JEENER et al.: "Nuclear magnetic resonance in solids: Thermodynamic effects of a pair of rf pulses"
- JOURNAL OF MAGNETIC RESONANCE, Band 81, Nr. 2, 1. Februar 1989, Seiten 333-338, Duluth, MN, US; R. KIMMICH et al.: "Theoretical treatment of volume-selective NMR spectroscopy (VOSY) applied to coupled spin systems"
- JOURNAL OF MAGNETIC RESONANCE, Band 83, Nr. 2, 15. Juni 1989, Seiten 299-308, Duluth, MN, US; E. ROMMEL et al.: "Slice excitation and localized NMR spectroscopy on the basis of spin locking"
- JOURNAL OF MAGNETIC RESONANCE, Band 86, Nr. 2, 1. Februar 1990, Seiten 264-272, Duluth, MN, US; E. ROMMEL et al.: "NMR imaging of solids by Jeener-Broekaert phase encoding"
- Chingas et all, "NMR Images of Solids", J. Magn. Res. 66, 530-535 (1986)

## Beschreibung

Die Erfindung betrifft ein Verfahren zur mehrdimensionalen Messung von magnetischer Resonanz in definierten kleinen Volumenbereichen einer Festkorper-Probe, bei dem die Probe in einem konstanten, homogenen Magnetfeld angeordnet und in vorbestimmter Weise mit einer Folge von Hochfrequenzimpulsen bestrahlt sowie einer Folge von Gradienten-Magnetfeld-Impulsen ausgesetzt wird, derart, daß die zu messende Magnetisierung der Spins für eine Zeitdauer aufrecht erhalten wird, die länger als eine Abschaltdauer der Gradienten-Magnetfeld-Impulse ist.

Ein Verfahren der vorstehend genannten Art ist aus der US-Z-Journal of Magnetic Resonance 66 (1986), Seiten 530 bis 535 bekannt.

Es ist allgemein bekannt, die Technik der magnetischen Resonanz, insbesondere der kernmagnetischen Resonanz, zur zwei- oder dreidimensionalen Messung in definierten kleinen Volumenbereichen von Proben einzusetzen. Insbesondere in der medizinischen Forschung und der medizinischen Diagnose werden auf diese Weise Messungen an lebendigem oder nicht-lebendigem menschlichem Gewebe vorgenommen. Hierbei unterscheidet man zum einen zwischen lokalisierten spektroskopischen Messungen, bei denen ein Kernresonanz-Spektrum nur eines kleinen Volumenbereiches aufgenommen wird und andererseits zwischen bildgebenden Verfahren, bei denen eine zwei- oder dreidimensionale Darstellung eines Körperteils als Bild der Spindichte oder Relaxationszeit aufgezeichnet wird.

Bislang sind derartige volumenselektive Messungen überwiegend an flüssigen Proben vorgenommen worden. Dies ist deswegen in einfacher Weise möglich, weil flüssige Proben infolge der Molekularbewegung relativ schmale Linien bzw. langsame Abfallzeiten der gepulsten Kernresonanzsignale aufweisen und während der relativ langen Dauer dieser Signale in der Größenordnung von mehreren 100 ms die erforderlichen Meßschritte vorgenommen werden können, um einen kleinen Volumenbereich zu selektieren und auszulesen. Diese Meßschritte bestehen im wesentlichen im Anlegen von Gradienten-Magnetfeld-Impulsen, für die aus technischen Gründen eine bestimmte Mindest-Einschaltzeit und eine Mindest-Ausschaltzeit erforderlich sind.

Will man derartige Messungen an Festkörpern durchführen, so ergibt sich das Problem, daß die Linienbreite bei Festkörpern infolge innerer Felder wesentlich größer bzw. die Abfallzeiten der angeregten Kernresonanzsignale wesentlich kurzer sind, nämlich in der Größenordnung von nur einigen 10 »s liegen. Aufgrunddessen ist es technisch nicht möglich, während dieser extrem kurzen Signaldauer die erforderlichen Lesegradienten oder phasenkodierenden Gradienten ein- und auszuschalten, vor allem dann, wenn starke Gradienten benötigt werden.

Man hat daher bei den bislang bekannt gewordenen vereinzelten Versuchen, volumenselektive Messungen an Festkörpern vorzunehmen, verschiedene Kunstgriffe angewendet, um die Linienbreite der Festkörpersignale zu vermindern bzw. die Abfallzeit der Signale zu verlängern.

Bei einem bekannten Verfahren der eingangs genannten Art wird eine Multipulssequenz (MREV-8) eingesetzt, um eine Verschmälerung der Linien zu erreichen. Die Multipulssequenz ist dabei ferner so ausgelegt, daß eine "Speicherung" der Magnetisierung für eine Zeit bewirkt wird, die ausreicht, um die Gradienten-Magnetfeld-Impulse wieder auszuschalten.

Das bekannte Verfahren hat jedoch den Nachteil, daß zur Signalaufnahme Lesegradienten eingesetzt werden müssen. Diese Lesegradienten bewirken indes eine Verschlechterung der Homogenität des Konstantmagnetfeldes und damit eine systematische Linienverbreiterung. Das bekannte Verfahren ist damit auf die Anwendung bei Proben mit schmalen Linien beschränkt und gestattet keine Untersuchungen der Linienform, weil die gemessene Linienform aus den genannten Gründen gegenüber der reinen Linienform infolge der Lesegradienten verbreitert ist.

Es ist ferner bekannt, dem Problem der breiten Linien bei Festkörpermessungen bzw. des schnellen Signalabfalls, dadurch zu begegnen, daß man die Probe um den sogenannten "magischen Winkel" dreht. Die Drehung muß dabei indes mit einer relativ hohen Rotationsfrequenz von mehreren kHz vorgenommen werden, damit die schnelle Molekülbewegung von Flüssigkeiten durch schnelle Rotation der Festkörper simuliert werden und damit die Lokalfelder ausgemittelt werden können. Bei derartig hohen Rotationsfrequenzen muß die Probe allerdings aus mechanischen Gründen rotationssymmetrisch sein. Auch bei rotationssymmetrischen Proben besteht allerdings die Gefahr, daß infolge der sehr hohen Rotationsfrequenzen eine Deformation der Probe eintritt.

Dieses bekannte Verfahren ist damit für Messungen an biologischen Proben, beispielsweise an extrahierten Zähnen, nicht einsetzbar, weil derartige natürliche Proben eine willkürliche, unregelmäßige Form haben und eine Deformation der Probe nicht zugelassen werden kann, wenn beispielsweise eine biologische Probe nach der Messung noch benötigt wird. Dies ist in der modernen Zahnmedizin z.B. der Fall, wenn ein kranker Zahn zunächst extrahiert, dann vermessen, weiterhin behandelt und schließlich wieder implantiert wird.

Der Erfindung liegt daher die Aufgabe zugrunde, ein Verfahren der eingangs genannten Art dahingehend weiterzubilden, daß zwei- und dreidimensionale Messungen ohne Zuhilfenahme von Lesegradienten möglich sind, so daß auch Linienformanalysen bei volumenselektiven Messungen an Festkörperproben möglich sind.

Diese Aufgabe wird erfindungsgemäß bei einer zweidimensionalen Messung dadurch gelöst, daß zunächst in einem ersten Zeitintervall die Magnetisierung nur einer Scheibe der Probe in eine um 90° gekippte Transversalmagnetisierung überführt wird, daß alsdann in einem zweiten Zeitintervall phasencodierende Gradienten-Magnetfeld-Impulse eingeschaltet werden, daß in einem dritten Zeitintervall während des Andauerns der phasencodierenden Gradienten-Magnetfeld-Impulse Hochfrequenz-Impulse auf die Probe eingestrahlt werden, welche die zu messende Transversalmagnetisierung im Volumenbereich in einen Multipol-Zustand überführen, der für die phasencodierenden Gradienten-Magnetfeld-Impulse unempfindlich ist und bis über den Zeitpunkt des in einem vierten Zeitintervall stattfindenden Abschaltens der phasencodierenden Gradienten-Magnetfeld-Impulse andauert, und daß schließlich in einem fünften Zeitintervall ein Hochfrequenz-Impuls auf die Probe eingestrahlt wird, wodurch der Multipol-Zustand wieder in eine Transversalmagnetisierung rückgeführt und diese als Signal ausgelesen wird.

Die der Erfindung zugrundeliegende Aufgabe wird ferner bei einer dreidimensionalen Messung erfindungsgemäß dadurch gelöst, daß in einem ersten Zeitintervall phasencodierende Gradienten-Magnetfeld-Impulse eingeschaltet werden, daß in einem zweiten Zeitintervall während des Andauerns der phasencodierenden Gradienten-Magnetfeld-Impulse Hochfrequenz-Impulse auf die Probe eingestrahlt werden, welche die zu messende Magnetisierung im Volumenbereich in einen Multipol-Zustand überführen, der für die phasencodierenden Gradienten-Magnetfeld-Impulse unempfindlich ist und bis über den Zeitpunkt des in einem vierten Zeitintervall stattfindenden Abschaltens der phasencodierenden Gradienten-Magnetfeld-Impulse andauert, und daß schließlich in einem fünften Zeitintervall ein Hochfrequenz-Impuls auf die Probe eingestrahlt wird, wodurch der Multipol-Zustand wieder rückgeführt und als Signal ausgelesen wird.

Die der Erfindung zugrundeliegende Aufgabe wird auf diese Weise vollkommen gelöst. Durch die Einstrahlung der Hochfrequenz-Impulse während des Andauerns der volumenselektiven Gradienten-Magnetfeld-Impulse wird nämlich die interessierende Magnetisierung in einen Zustand (Dipol- oder Quadrupol-Zustand) überführt, in dem diese für die Magnetfeld-Impulse nicht mehr empfindlich ist und hinreichend lange andauert, damit die Magnetfeld-Impulse in technisch machbarer Weise abgeschaltet werden können. Das anschließende Auslesen der Signale geschieht dann ohne die Verwendung von Lesegradienten, so daß die Linienform der Signale unverfälscht bleibt und ausgewertet werden kann.

Auf diese Weise können völlig neuartige volumenselektive Messungen an Festkörpern vorgenommen werden. So können vorteilhafterweise nicht nur biologische Proben, beispielsweise Knochen oder die bereits erwähnten extrahierten Zähne, ausgemessen werden, es können vielmehr auch Messungen z.B. an Kunststoffen vorgenommen werden, um z.B. die Kettenorientierung der Kunststoffe zu bestimmen. Wird beispielsweise Kunststoff extrudiert, um Behälter oder dgl. herzustellen, so kann durch volumenselektive Vermessung der Werkstücke festgestellt werden, wie die Molekülorientierung bzw. Kettenorientierung des Kunststoffes infolge der Extrusion an den verschiedenen Punkten des Werkstückes beschaffen ist. Da die Kettenorientierung der Kunststoffe ein wesentliches Maß für deren Festigkeit ist, kann z.B. bei Behältern (Kunststoffflaschen) festgestellt werden, ob diese in allen Bereichen hinreichend stabil sind.

Bei einer besonders bevorzugten Ausführungsform des erfindungsgemäßen Verfahrens zur zweidimensionalen Messung wird die Transversalmagnetisierung im ersten Zeitintervall durch eine erste Impulsfolge erzeugt, die aus einem ersten, harten 90°-Hochfrequenz-Impuls, einem unmittelbar daran anschließenden Spinlock-Impuls mit um 90° gegenüber dem ersten 90°-Hochfrequenz-Impulse verschobener Phasenlage sowie einem unmittelbar daran anschließenden zweiten 90°-Hochfrequenz-Impuls mit um 180° gegenüber dem ersten 90°-Hochfrequenz-Impuls verschobener Phasenlage besteht.

Diese Impulsfolge zur Erzeugung der Transversalmagnetisierung, die an sich aus dem Dokument "J. Magn. Res. 83, Seite 299 bis 308 (1989) bekannt ist, hat den Vorteil, daß nach Abschluß dieser Impulsfolge die gesamte Magnetisierung der selektierten Schicht in z-Richtung ausgerichtet und "gelockt" ist, d.h. nicht dephasiert, während die Magnetisierung des gesamten übrigen Volumens außerhalb der Schicht unkontrolliert dephasiert und daher keine Signalanteile während des weiteren Ablaufs der Messung liefert.

Es ist weiterhin bei beiden eingangs genannten Verfahren besonders bevorzugt, wenn die zur Überführung in den und aus dem Multipol-Zustand eingestrahlte zweite Impulsfolge aus einem 90°-Hochfrquenz-Impuls, einem im zeitlichen Abstand folgenden ersten 45°-Hochfrequenz-Impuls sowie einem im weiteren zeitlichen Abstand folgenden zweiten 45°-Hochfrequenz-Impuls besteht, wobei die 45°-Hochfrequenz-Impulse vorzugsweise in ihrer Phasenlage gegenüber dem 90°-Hochfrequenz-Impuls alternierend gleichphasig bzw. beide um 90° verschoben eingestellt werden.

Die Verwendung dieser an sich aus der US-Z-Physical Review 157 (1967), Seiten 232 bis 240 bekannte Impulsfolge hat den Vorteil, daß die Tatsache der Überführung in einen Multipol-Zustand ausgenutzt wird, um die Magnetisierung gegenüber dem Abschalten der volumenselektiven Gradienten-Magnetfeld-Impulse unempfindlich zu machen und gleichzeitig die interessierende Magnetisierung so weit zeitlich zu verlängern, daß die Magnetfeld-Impulse in ausreichender Zeit abgeschaltet werden können. Das Auslesen des Signals kann dann ohne Anwesenheit von Magnetfeld-Impulsen geschehen, so daß die Linienform in unverfälschter Weise erhalten bleibt.

Es versteht sich, daß die vorliegende Erfindung, auch wenn sie nachstehend am Beispiel der Protonen-Kernresonanz erläutert werden wird, auch bei anderen Arten der magnetischen Resonanz (z.B. der ESR) einsetzbar ist.

Weitere Vorteile ergeben sich aus der Beschreibung und der beigefügten Zeichnung.

Es versteht sich, daß die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine Impulsfolge für ein erstes Ausführungsbeispiel des erfindungsgemäßen Verfahrens zur zweidimensionalen Messung;
- Fig. 2: eine Darstellung, ähnlich Fig. 1, jedoch für eine dreidimensionale Messung;
- Fig. 3: das Ergebnis einer bildgebenden Messung an einer Probe mit unterschiedlichen Materialbereichen;
- Fig. 4: eine Variante zur Messung der Fig. 3;
- Fig. 5: eine volumenselektive Messung von Kernresonanzspektren an einer Festkörperprobe mit unterschiedlichen Materialbereichen;
- Fig. 6: vergrößerte Darstellungen zweier Kernresonanzspektren aus Fig. 5;
- Fig. 7: zwei Protonenspektren einer Kunststoffprobe, die in unterschiedlichen Orientierung der Probe zum Magnetfeld aufgenommen wurden;
- Fig. 8: ein Diagramm zur Veranschaulichung der Winkelabhängigkeit der Frequenz des Signalmaximums im Hinblick auf die Messung der Fig. 7.

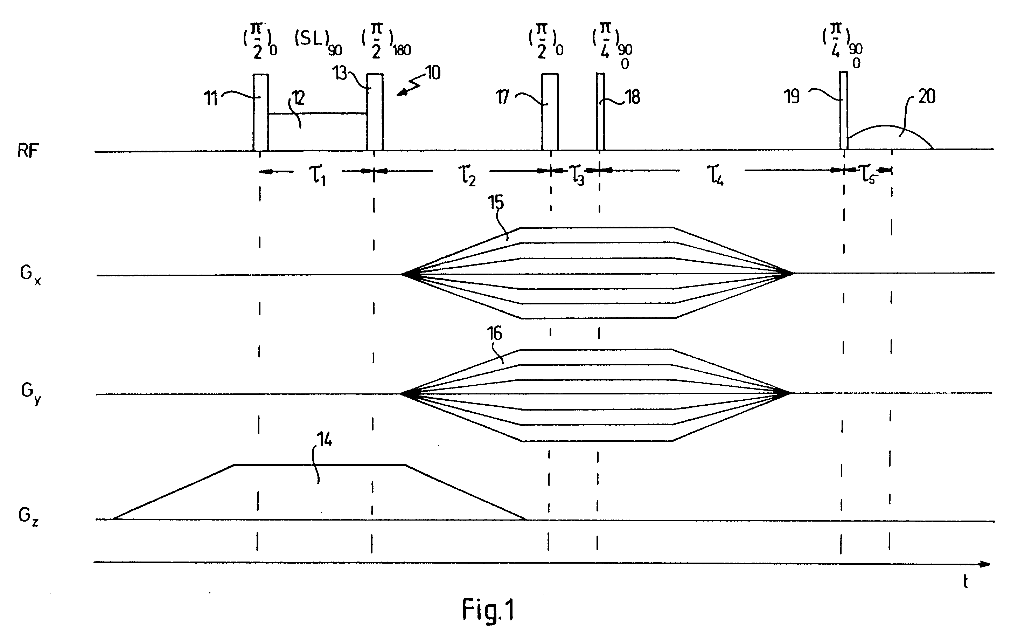

Bei der Darstellung der Fig. 1 sind über der Zeit t untereinander auf einer Achse RF verschiedene Hochfrequenzen-Impulse und auf Achsen Gₓ, G_{y} und G_{z} Gradienten-Magnetfeld-Impulse dargestellt.

Zur zweidimensionalen volumenselektiven Messung von Kernresonanzsignalen an Festkörperproben wird zunächst eine Scheibenselektion mit Hilfe einer Impulsfolge 10 vorgenommen, die aus einem ersten 90°-Impuls 11, einem unmittelbar daran anschließenden Spinlock-Impuls 12 sowie aus einem zweiten 90°-Impuls 13 besteht, wobei die gesamte Impulsfolge 10 in Anwesenheit eines Gradienten-Magnetfeld-Impulses 14 in z-Richtung eingestrahlt wird.

Die Impulsfolge 10 klappt mit dem ersten "harten" 90°-Impuls die gesamte Magnetisierung der durch den Gradienten-Magnetfeld-Impuls 14 definierten Scheibe oder Schicht in die z-Achse und erzeugt auf diese Weise eine Transversalmagnetisierung.

Der anschließende Spinlock-Impuls 12 ist gegenüber dem ersten 90°-Impuls 11 um 90° phasenverschoben, so daß das Hochfrequenzfeld richtig in Magnetisierungsrichtung zeigt und nur für die Spins wirksam ist, die sich in Resonanz befinden, d.h. für diejenigen Spins, die in der ausgewählten Scheibe angeordnet sind. Auf diese Weise wird die Magnetisierung der Scheibe "gelockt", d.h. sie dephasiert nicht und wird in ihrem Zustand festgehalten. Die Magnetisierung der übrigen Volumenbereiche der Probe dephasiert hingegen unkontrolliert, so daß sie nicht zur weiteren Signalerzeugung beitragen kann.

Die Impulsfolge 10, die auch als LOSY-Pulsfolge in dem obengenannten Artikel in J. Magn. Res. 83 (1989) beschrieben ist, hat den Vorteil, daß keine geformten Hochfrequenz-Impulse (sinc-Impulse oder dgl.) benötigt werden, und daß der z-Gradienten-Magnetfeld-Impuls 14 auf eine Größenordnung beschränkt ist, die nur der Linienbreite entspricht.

Nach Ablauf des von der Impulsfolge 10 bestimmten Zeitintervalls τ₁ schließt sich ein zweiten Zeitintervall τ₂ an, in dem zwei Phasen-Gradienten-Magnetfeld-Impulse 15 und 16 in x- bzw. y-Richtung eingeschaltet werden. Diese beiden Magnetfeld-Impulse 15, 16 sind, wie in Fig. 1 angedeutet, phasenkodierend, d.h. ihre Amplitude wird schrittweise durchgeschaltet.

Es ist in Fig. 1 ferner deutlich zu erkennen, daß zum Einschalten und zum Ausschalten der Magnetfeldimpulse 14, 15, 16 jeweils eine bestimmte Zeit erforderlich ist, deren Dauer durchaus beachtliche Länge im hier interessierenden Zusammenhang hat.

Nachdem die Phasen-Gradienten-Magnetfeld-Impulse 15, 16 eingeschaltet sind, schließt sich ein drittes Zeitintervall τ₃ an, zu dessen Beginn ein 90°-Hochfrequenz-Impuls 17 und zu dessen Ende ein 45°-Hochfrequenz-Impuls 18 auf die Probe eingestrahlt werden. Auf diese Weise wird je nach gemessener Probe ein Dipol- oder Quadrupol-Zustand erzeugt, der einerseits für eine längere Zeitdauer wirkt, als dies der natürlichen Linienbreite eines Festkörpersignales entsprechen würde, andererseits aber auch bewirkt, daß das Signal in diesem Zustand unempfindlich gegenüber den Gradienten-Magnetfeld-Impulsen 15 und 16 ist.

Es ist daher möglich, in einem darauffolgenden vierten Zeitintervall τ₄ die beiden Phasen-Gradienten-Magnetfeld-Impulse 15 und 16 wieder abzuschalten, wie es in Fig. 1 deutlich zu erkennen ist, und zwar ohne daß die gewünschte Information, d.h. die Magnetisierung, durch vorzeitiges Abklingen verloren geht.

Nachdem die Phasen-Gradienten-Magnetfeld-Impulse 15 und 16 abgeschaltet sind, kann in einem fünften Zeitintervall τ₅, das wieder die Länge τ₃ hat, durch einen zweiten 45°-Hochfrequenz-Impuls 19 das Signal wieder aus dem Dipol- bzw. Quadrupol-Zustand rückgeführt und als Signal 20 ausgelesen werden.

Der Zeitpunkt des Signalauslesens liegt damit nach dem Ende der Phasen-Gradienten-Magnetfeld-Impulse 15 und 16, so daß die Linienform der gemessenen Kernresonanzsignale unverändert ist, da eine Homogenitätsverschlechterung des Magnetfeldes durch zusätzliche Magnetfeld-Impulse nicht vorliegt.

Im Rahmen der vorstehend beschriebenen Messung werden jeweils zwei Einzelmessungen für jede Amplitudeneinstellung der Phasen-Gradienten-Magnetfeld-Impulse 15 und 16 vorgenommen. Dies geschieht dadurch, daß die beiden 45°-Hochfrequenz-Impulse 18 und 19 während der ersten Einzelmessung beide gleichphasig mit dem vorhergehenden 90°-Hochfrequenz-Impuls 17 eingestellt werden, während in der darauffolgenden Einzelmessung die Phase der beiden 45°-Hochfrequenz-Impulse 18 und 19 um 90° gedreht wird. Diese Vorgehensweise, die auch als serielle Quadratur-Detektion bezeichnet werden kann, vermeidet das Auftreten von Spiegeln während der Signalaufnahme. Auf diese Weise verdoppelt sich zwar die Gesamt-Meßzeit, dies ist jedoch bei Festkörperproben weniger kritisch als bei Messungen an Flüssigkeiten, insbesondere an lebendem menschlichem Gewebe, weil im letztgenannten Fall bei langen Meßdauern Störungen durch Artefakte befürchtet werden müssen.

Durch die beiden aufeinanderfolgenden Einzelmessungen mit den um 90° verdrehten Phasen der 45°-Hochfrequenz-Impulse 18 und 19 werden somit der Realteil und der Imaginärteil im Zeitbereich und damit die gesamte interessierende spektrale Information gemessen.

Die Dauer des Zeitintervalls τ₃ wird zur Erzielung einer optimalen Signalamplitude so eingestellt, daß sie ungefähr dem steilsten Abfall des freien Induktionssignals entspricht. Auf diese Weise werden ca. 56 % der anfänglichen Magnetisierung als Echosignal ausgewertet.

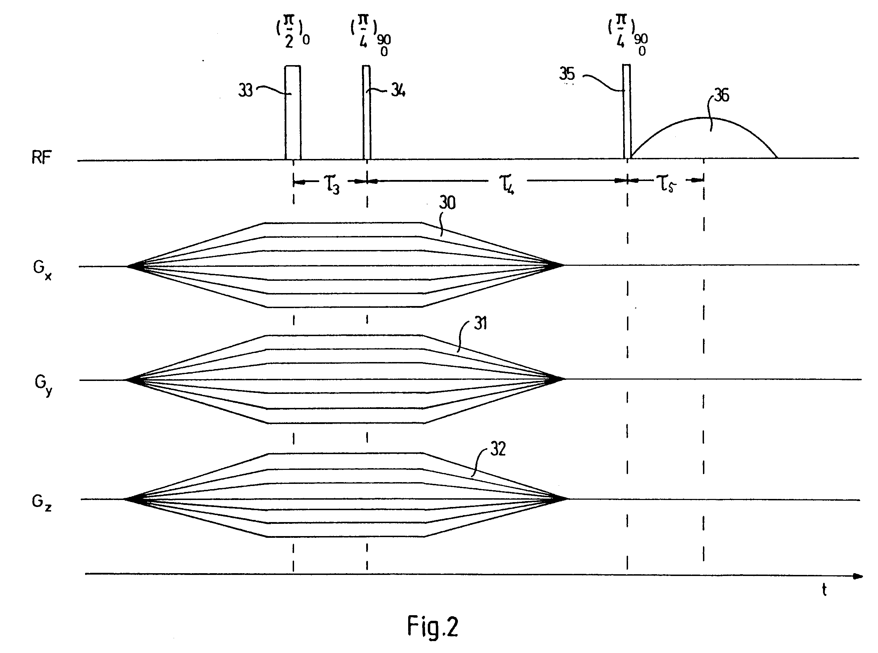

Bei der in Fig. 2 dargestellten Variante werden dreidimensionale Messungen durchgeführt.

Im Fall der Fig. 2 wird auf eine Scheibenanregung zu Beginn des Experimentes verzichtet und es werden sogleich drei Phasen-Gradienten-Magnetfeld-Impulse 30, 31, 32 in x-, y- und z-Richtung eingeschaltet, wie in Fig. 2 deutlich zu erkennen ist. Wenn die drei Magnetfeld-Impulse 30 bis 32 eingeschaltet sind, vollzieht sich das Experiment in ähnlicher Weise wie in Fig. 1 ab dem dritten Zeitintervall τ₃. Hierzu wird beim Experiment der Fig. 2 zunächst ein 90°-Hochfrequenz-Impuls 33 und dann im Zeitabstand τ₃ ein erster 45°-Hochfrequenz-Impuls 34 eingestrahlt, wobei die physikalischen Phänomene dieselben sind, wie sie vorstehend zum Experiment der Fig. 1 erläutert wurden.

Es werden nun die drei Gradienten-Magnetfeld-Impulse 30 bis 32 abgeschaltet und alsdann nach Ablauf der Zeitdauer t₄ ein zweiter 45°-Hochfrequenz-Impuls 35 auf die Probe eingestrahlt, um anschließend ein Signal 36 auszulesen.

Auch in diesem Falle gilt, daß in zwei aufeinanderfolgenden Teilmessungen die Phasen der beiden 45°-Hochfrequenz-Impulse 34 und 35 gemeinsam um 90° hin- und hergeschaltet werden.

Im folgenden sollen einige Meßergebnisse des in Fig. 1 veranschaulichten Verfahrens erläutert werden. Die Messungen wurden an einem Tomographen mit einem supraleitenden Magnetsystem einer Feldstärke von 4,7 T bei einer Protonen-Meßfrequenz von 200 MHz durchgeführt. Es wurden röhrenförmige Gradientenspulen von 30 bzw. 15 cm Durchmesser verwendet. Die maximalen Phasengradienten betrugen 7,5 G/cm. Die Gradientenschaltzeit betrug 2 ms. Die Phasengradienten wurden in jeweils 32 Schritten verstellt.

Für die nachstehend geschilderten Messungen wurde ein spezieller Probenkopf eingesetzt, dessen Hochfrequenz-Solinoidspule einen Durchmesser von 1 cm aufwies. Die Lange der 90°-Hochfrequenz-Impulse betrug 5 »s. Die Phasencodierzeit τ₃ wurde mit 85 »s eingestellt. Die Schaltzeit der Gradienten-Magnetfeld-Impulse betrug etwa 2 »s, so daß die Zeit τ₄ für die Überführung in den Multipolzustand mit etwa 10 ms eingestellt wurde.

Die Messungen wurden an Proben durchgeführt, die aus Hexamenthylbenzen und Polytetrafluorethylen (Teflon) bestanden. Bei Raumtemperatur und einer Meßfrequenz von 200 MHz beträgt die Spin-Gitter-Relaxationszeit von Hexamethylbenzin etwa 360 ms. Die dipolare Relaxationszeit kann auf weniger als 100 ms geschätzt werden, während die transveralse Relaxationszeit etwa 40 »s beträgt.

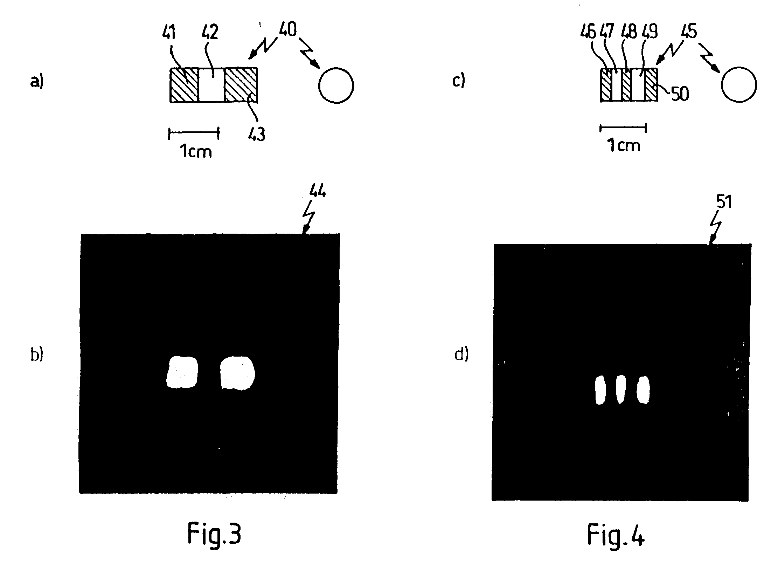

In den Fig. 3 und 4 sind jeweils die Ergebnisse bildgebender Messungen dargestellt.

Fig. 3a zeigt eine erste Probe 40, die aus einem ersten Materialbereich 41, einer Leerstelle 42 und einem zweiten Materialbereich 43 besteht. Die zugehörige Bildaufnahme ist mit 44 bezeichnet und man erkennt deutlich die beiden Materialbereiche 41 und 43 als weiße Flecken in dem ansonsten schwarzen Hintergrund. Aufgrund der gewählten 32 Phasenschritte konnte eine 32 x 32 Phasenkodierung mit einer entsprechenden Zahl von Bildpunkten erreicht werden. Aufgrunddessen ergab sich eine räumliche Auflösung von 1,7 mm. Es wurden nur die Spinecho-Amplituden ausgewertet. Die Gesamtmeßzeit betrug ca. 4 Minuten.

Eine entsprechende Messung zeigt Fig. 4 mit einer zweiten Probe 45, die insgesamt drei Materialbereiche 46, 48 und 50 und zwei Leerstellen 47 aufwies. Wie die Bildaufnahme 51 zeigt, ist auch diese feiner strukturierte Probe 45 deutlich aufgelöst dargestellt.

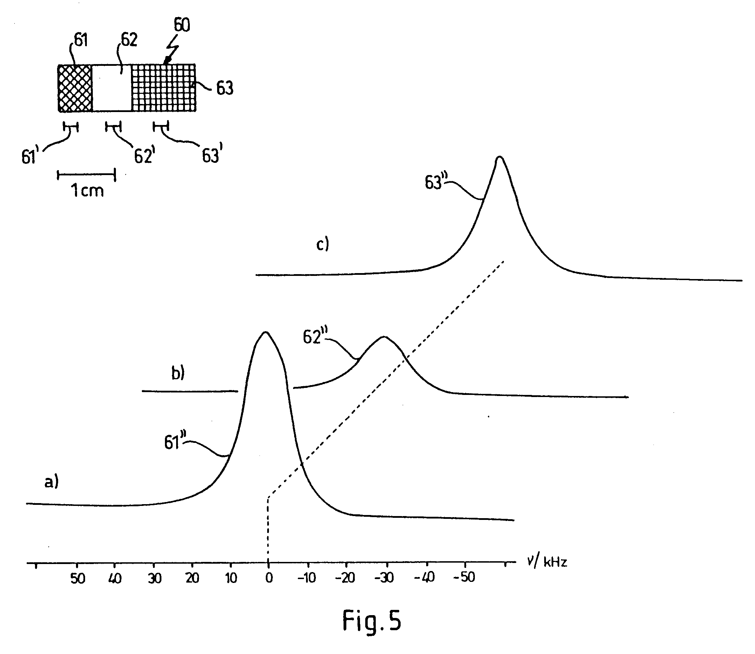

Fig. 5 zeigt oben links eine dritte Probe 60 mit einem ersten Materialbereich 61 aus Hexamethylbenzen, einem zweiten Materialbereich 62 aus Tetrafluorethylen und einem dritten Materialbereich 63 aus Polyethylen.

Wie mit 61′, 62′ und 63′ angedeutet, wurden in diesen drei Bereichen 61, 62, 63 volumenselektiv Kernresonanzen angeregt und die entsprechenden Kernresonanzlinien vermessen, wie in Fig. 5 unten rechts dargestellt. Dort zeigen die Darstellungen a), b) und c) drei Spektrallinien 61˝, 62˝ und 63˝, die zu den drei genannten Materialbereichen 61, 62 und 63 an den Positionen 61′, 62′ und 63′ gehören.

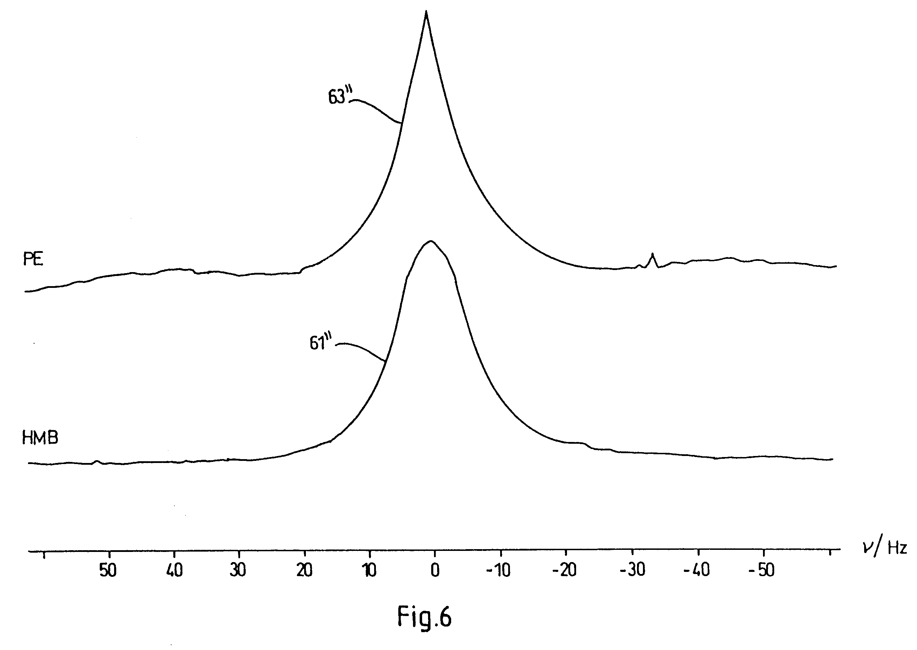

Man erkennt aus den Darstellungen 5a), b) und c) deutlich, daß unterschiedliche Signalintensitäten und unterschiedliche Linienformen gemessen wurden. Dies wird besonders deutlich aus der vergrößerten Darstellung der Fig. 6, wo die Linien 61˝ für Hexamethylbenzin und 63˝ für Polyethylen nochmals im einzelnen dargestellt sind.

Die gemessenen Signallinien können nun nach unterschiedlichen Gesichtspunkten ausgewertet werden. So kann man beispielsweise zu jedem Signalmaximum die zugehörige Frequenz ermitteln, oder die Linienbreite oder Momente höherer Ordnung. Vorausgesetzt, daß diese Parameter bestimmten Materialeigenschaften zugeordnet werden können, ist es prinzipiell möglich, diese Meßergebnisse bildgebend darzustellen, indem jedem Meßwert ein zugehöriger Wert auf einer vorbestimmten Grauskala zugeordnet wird.

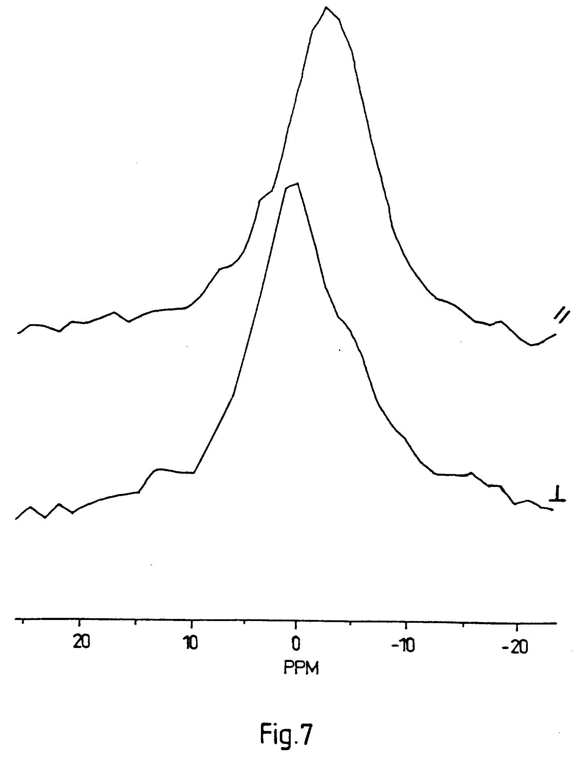

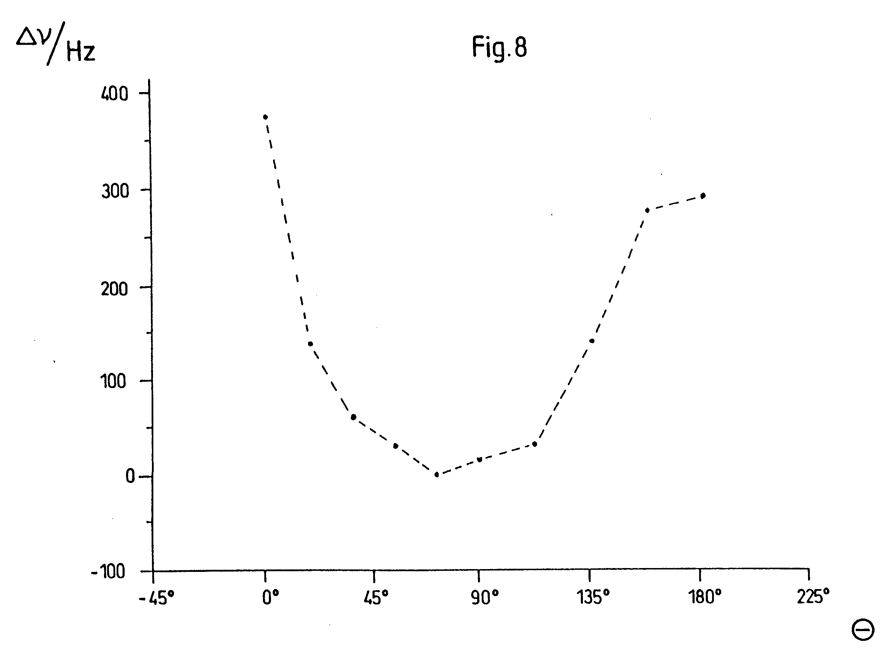

In Fig. 7 ist das Meßergebnis einer Probe eines polyparaaromatischen Amids dargestellt, wie es unter der Bezeichnung Kevlar im Handel ist. Die Probe wurde bei den Messungen in unterschiedlicher Weise zum Magnetfeld ausgerichtet, nämlich einmal parallel und einmal senkrecht zum Magnetfeld, wie an den beiden Linien in Fig. 7 mit entsprechenden Symbolen angezeigt ist. Man erkennt, daß sich sowohl die Linienform wie auch die Lage des Maximums in Abhängigkeit von der Orientierung zum externen Magnetfeld ändert. Die Winkelabhängigkeit des Signalmaximus ist schließlich in Fig. 8 aufgetragen. Der hier dargestellte Parameter kann z.B. verwendet werden, um Kontraste in Bildern zu erzeugen, in denen die Kettenorientierung von Kunststoffen dargestellt werden soll.

## Patentansprüche

1. Verfahren zur zweidimensionalen Messung von magnetischer Resonanz in definierten kleinen Volumenbereichen einer Festkörper-Probe (40; 45; 60), bei dem die Probe (40; 45; 60) in einem konstanten, homogenen Magnetfeld angeordnet und in vorbestimmter Weise mit einer Folge von Hochfrequenz-Impulsen (11, 12, 13, 17, 18, 19) bestrahlt sowie einer Folge von Gradienten-Magnetfeld-Impulsen (14 bis 16) ausgesetzt wird, derart, daß die zu messende Magnetisierung der Spins für eine Zeitdauer aufrechterhalten wird, die länger als eine Abschaltdauer der Gradienten-Magnetfeld-Impulse (14 bis 16) ist, bei dem zunächst in einem ersten Zeitintervall (τ₁) die Magnetisierung nur einer Scheibe der Probe (40; 45; 60) in eine um 90° gekippte Transversalmagnetisierung überführt wird, bei dem alsdann in einem zweiten Zeitintervall (τ₂) phasencodierende Gradienten-Magnetfeld-Impulse (15, 16) eingeschaltet werden, bei dem in einem dritten Zeitintervall (τ₃) während des Andauerns der phasencodierenden Gradienten-Magnetfeld-Impulse (15, 16) Hochfrequenz-Impulse (17, 18) auf die Probe (40; 45; 60) eingestrahlt werden, welche die zu messende Transversalmagnetisierung im Volumenbereich in einen Multipol-Zustand überführen, der für die phasencodierenden Gradienten-Magnetfeld-Impulse (15, 16) unempfindlich ist und bis über den Zeitpunkt des in einem vierten Zeitintervall (τ₄) stattfindenden Abschaltens der phasencodierenden Gradienten-Magnetfeld-Impulse (15, 16) andauert, und bei dem schließlich in einem fünften Zeitintervall (τ₅) ein Hochfrequenz-Impuls (19) auf die Probe (40; 45; 60) eingestrahlt wird, wodurch der Multipol-Zustand wieder in eine Transversalmagnetisierung rückgeführt und diese als Signal (20) ausgelesen wird.

2. Verfahren nach Anspruch 1, dadurch gekennzeichnet, daß die Transversalmagnetisierung im ersten Zeitintervall (τ₁) durch eine erste Impulsefolge (10) erzeugt wird, die aus einem ersten, harten 90°-Hochfrequenz-Impuls (11), einem unmittelbar daran anschließenden Spinlock-Impuls (12) mit um 90° gegenüber dem ersten 90°-Hochfrequenz-Impuls (11) verschobener Phasenlage sowie einem unmittelbar daran anschließenden zweiten 90°-Hochfrequenz-Impuls (13) mit um 180° gegenüber dem ersten 90°-Hochfrequenz-Impuls (11) verschobenen Phasenlage besteht.

3. Verfahren zur dreidimensionalen Messung von magnetischer Resonanz in definierten kleinen Volumenbereichen einer Festkörper-Probe, bei dem die Probe in einem konstanten, homogenen Magnetfeld angeordnet und in vorbestimmter Weise mit einer Folge von Hochfrequenz-Impulsen (33 bis 35) bestrahlt sowie einer Folge von Gradienten-Magnetfeld-Impulsen (30 bis 32) ausgesetzt wird, derart, daß die zu messende Magnetisierung des Spins für eine Zeitdauer aufrechterhalten wird, die länger als eine Abschaltdauer der Gradienten-Magnetfeld-Impulse (30 bis 32) ist, bei dem in einem ersten Zeitintervall (τ₂) phasencodierende Gradienten-Magnetfeld-Impulse (30 bis 32) eingeschaltet werden, bei dem in einem zweiten Zeitintervall (τ₃) während des Andauerns der phasencodierenden Gradienten-Magnetfeld-Impulse (30 bis 32) Hochfrequenz-Impulse (33 und 34) auf die Probe eingestrahlt werden, welche die zu messende Magnetisierung im Volumenbereich in einen Multipol-Zustand überführen, der für die phasencodierenden Gradienten-Magnetfeld-Impulse (30 bis 32) unempfindlich ist und bis über den Zeitpunkt des in einem vierten Zeitintervall (τ₄) stattfindenden Abschaltens der phasencodierenden Gradienten-Magnetfeld-Impulse (30 bis 32) andauert, und bei dem schließlich in einem fünften Zeitintervall (τ₅) ein Hochfrequenz-Impuls (35) auf die Probe eingestrahlt wird, wodurch der Multipol-Zustand wieder rückgeführt und als Signal (36) ausgelesen wird.

4. Verfahren nach einem oder mehreren der Ansprüche 1 bis 3, dadurch gekennzeichnet, daß die zur Überführung in den aus dem Multipol-Zustand eingestrahlte zweite Impulsefolge aus einem 90°-Hochfrequenz-Impuls (17; 33), einem in zeitlichem Abstand (τ₃) folgenden ersten 45°-Hochfrequenz-Impuls (18; 34) sowie einem in weiterem zeitlichen Abstand (τ₄) folgenden zweiten 45°-Hochfrequenz-Impuls (19; 35) besteht, wobei vorzugsweise die 45°-Hochfrequenz-Impulse (18, 19; 34, 35) in ihrer Phasenlage gegenüber dem 90°-Hochfrequenz-Impuls (17; 33) alternierend gleichphasig bzw. beide um 90° verschoben eingestellt werden.

5. Verfahren nach einem oder mehreren der Ansprüche 1 bis 4, dadurch gekennzeichnet, daß die Gradienten-Magnetfeld-Impulse (15, 16; 30 bis 32) schrittweise phasencodierend eingestellt werden.

## Claims

1. A method for the two-dimensional measurement of magnetic resonance in defined small volume areas of a solid-state sample (40; 45; 60), the sample (40; 45; 60) being arranged within a constant, homogeneous magnetic field, being, further, irradiated in a predetermined manner with a sequence of high-frequency pulses (11, 12, 13, 17, 18, 19), and being exposed to a sequence of gradient magnetic field pulses (14 - 16) for maintaining during a period of time the spin magnetization to be measured, the period of time being longer than a switch-off time of the gradient magnetic field pulses (14 - 16), characterized in that initially within a first time interval (τ₁) the magnetization of one slice of the sample (40; 45; 60) only is transferred into a transverse magnetization tipped by 90°, that, subsequently, within a second time interval (τ₂) phase-coding gradient magnetic field pulses (15, 16) are switched on, that within a third time interval (τ₃) during the persistence of the phase-coding gradient magnetic field pulses (15, 16) high-frequency pulses (17, 18) are irradiated on the sample (40; 45; 60) transferring the transverse magnetization to be measured within a volume area into a multi-pole state being insensitive for the phase-coding gradient magnetic field pulses (15, 16) and being persistent beyond the moment in time of the switching-off of the phase-coding gradient magnetic field pulses (15, 16) within a fourth time interval, and that, finally, within a fifth time interval (τ₃) a high-frequency pulse (19) is irradiated on the sample (40; 45; 60), whereby the multi-pole state is again re-transferred into a transverse magnetization, the latter being read-out as a signal (20).

2. The method of claim 1, characterized in that the transverse magnetization is generated within the first time interval (τ₁) by means of a first sequence of pulses (10), consisting of a first, hard 90°-high-frequency-pulse (11), an immediately subsequent spin-lock pulse (12) having a phase being shifted by 90° with respect to the first 90°-high-frequency-pulse (11), as well as an immediately subsequent second 90°-high-frequency-pulse (13) having a phase being shifted by 180° with respect to the first 90°-high-frequency-pulse (11).

3. A method for the three-dimensional measurement of magnetic resonance in defined small volume areas of a solid-state sample, the sample being arranged within a constant, homogeneous magnetic field, being, further, irradiated in a predetermined manner with a sequence of high-frequency pulses (33 - 35), and being exposed to a sequence of gradient magnetic field pulses (30 - 32) for maintaining during a period of time the spin magnetization to be measured, the period of time being longer than a switch-off time of the gradient magnetic field pulses (30 - 32), characterized in that initially within a first time interval (τ₂) phase-coding gradient magnetic field pulses (30 - 32) are switched on, that in a second time interval (τ₃) during the persistence of the phase-coded gradient magnetic field pulses (30 - 32) high-frequency-pulses (33 and 34) are irradiated on the sample for transferring the magnetization to be measured within the volume area into a multi-pole state being insensitive for the phase-coding gradient magnetic field pulses (30 - 32) and being persistent beyond a moment in time of the switching-off of the phase-coding gradient magnetic field pulses (30 - 32) within a fourth time interval, and that, finally, within a fifth time interval (τ₃) a high-frequency-pulse (35) is irradiated on the sample, whereby the multi-pole state is again retransferred and is read out as a signal (36).

4. The method of one or more of claims 1 through 3, characterized in that the second sequence of pulses for the transfer into the multi-pole state consists of a first 90°-high-frequency-pulse (17; 33), a first 45°-high-frequency-pulse (18; 34) following after a distance in time (τ₃) as well of a second 45°-high-frequency-pulse (19; 35) following after a further distance in time (τ₄), the 45°-high-frequency-pulses (18, 19; 34, 35) having, preferably, a phase being alternately in phase and both shifted by 90°, respectively, with respect to the 90°-high-frequency-pulse (17; 33).

5. The method of one or more of claims 1 through 4, characterized in that the gradient magnetic field pulses (15, 16; 30 - 32) are set to be stepwise phase-coding.

## Revendications

1. Procédé de mesure de la résonance magnétique bidimensionnelle dans de petits volumes définis d'un échantillon solide (40 ; 45 ; 60) ; dans lequel l'échantillon (40 ; 45 ; 60) est placé dans un champ magnétique homogène et constant et est irradié d'une façon prédéterminée par une succession d'impulsions haute fréquence (11, 12, 13, 17, 18, 19), et également soumis à une succession d'impulsions de champ magnétique à gradients (14 à 16), de telle sorte que la magnétisation des spins à mesurer est maintenue constante pendant une durée supérieure au temps de coupure des impulsions de champ magnétique à gradients (14 à 16) ; dans lequel, dans un premier intervalle de temps (τ1), la magnétisation n'est d'abord effectuée que sur une tranche de l'échantillon (40 ; 45 ; 60) dans une magnétisation transversale pivotée de 90° ; dans lequel, dans un second intervalle de temps (τ2), des impulsions de champ magnétique à gradients à codage de phase (15, 16) sont ensuite appliquées ; dans lequel dans un troisième intervalle de temps (τ3), pendant la persistance des impulsions de champ magnétique à gradients à codage de phase (15, 16), l'échantillon (40 ; 45 ; 60) est soumis à des impulsions haute fréquence (17, 18) qui transposent la magnétisation transversale à mesurer dans le volume en un état multipolaire qui est insensible aux impulsions de champ magnétique à gradients à codage de phase (15, 16) et qui persistent jusqu'à la coupure des impulsions de champ magnétique à gradients à codage de phase (15, 16), qui intervient dans un quatrième intervalle de temps (τ4) ; et dans lequel, dans un cinquième intervalle de temps (τ5), une impulsion haute fréquence (19) est enfin envoyée sur l'échantillon (40 ; 45 ; 60), l'état multipolaire étant ainsi retransposé en une magnétisation transversale, celle-ci pouvant être mesurée sous forme de signal (20).

2. Procédé selon la revendication 1, caractérisé en ce que la magnétisation transversale du premier intervalle de temps (τ1) est obtenue par une première séquence d'impulsions (10) comportant une première impulsion haute fréquence dure à 90° (11), suivie immédiatement d'une impulsion de blocage de spin (12) déphasée de 90° par rapport à la première impulsion haute fréquence à 90° (11), suivie elle-même immédiatement par une seconde impulsion haute fréquence à 90° (13) déphasée de 180° par rapport à la première impulsion haute fréquence à 90° (11).

3. Procédé de mesure de la résonance magnétique tridimensionnelle dans de petits volumes définis d'un échantillon solide ; dans lequel l'échantillon est placé dans un champ magnétique homogène et constant et est irradié d'une façon prédéterminée par une succession d'impulsions haute fréquence (33 à 35), et également soumis à une succession d'impulsions de champ magnétique à gradients (30 à 32), de telle sorte que la magnétisation des spins à mesurer est maintenue constante pendant une durée supérieure au temps de coupure des impulsions de champ magnétique à gradients (30 à 32) ; dans lequel, dans un premier intervalle de temps (τ2), des impulsions de champ magnétique à gradients à codage de phase (30 à 32) sont appliquées ; dans lequel, dans un second intervalle de temps (τ3), pendant la persistance des impulsions de champ magnétique à gradients à codage de phase (30 à 32), l'échantillon est soumis à des impulsions haute fréquence (33 et 34) qui transposent la magnétisation à mesurer dans le volume en un état multipolaire qui est insensible aux impulsions de champ magnétique à gradients à codage de phase (30 à 32) et qui persiste jusqu'à la coupure des impulsions de champ magnétique à gradients à codage de phase (30 à 32), qui intervient dans un quatrième intervalle de temps (τ4), et en ce que, dans un cinquième intervalle de temps (τ5), une impulsion haute fréquence (35) est enfin envoyée sur l'échantillon, l'état multipolaire étant retransposé et mesuré sous forme de signal (36).

4. Procédé selon l'une ou plusieurs des revendications 1 à 3, caractérisé en ce que la seconde séquence d'impulsions émise pour effectuer le transfert à l'état multipolaire et le transfert en retour, est constituée par une impulsion haute fréquence à 90° (17 ; 33), suivie par une première impulsion haute fréquence à 45° (18 ; 34) décalée d'un premier intervalle de temps (τ3), ainsi que par une seconde impulsion haute fréquence à 45° (19 ; 35) décalée d'un second intervalle de temps (τ4), les impulsions haute fréquence à 45° (18, 19 ; 34, 35) étant de préférence, par rapport à l'impulsion haute fréquence à 90° (17 ; 33), alternativement en phase ou toutes deux déphasées de 90°.

5. Procédé selon l'une ou plusieurs des revendications 1 à 4, caractérisé en ce que les impulsions de champ magnétique à gradients (15, 16 ; 30 à 32) sont à codage de phase par pas successifs.
